# EUROPÄISCHE PATENTANMELDUNG

(11) **EP 1 128 422 A1**
(43) Veröffentlichungstag der Anmeldung: **29.08.2001**
(21) Anmeldenummer: 00103726.6
(22) Anmeldetag: 22.02.2000
(51) Int. Cl.: H01L 21/331, H01L 21/8249

(54) **Verfahren zur Herstellung eines bipolaren Transistors im BiCMOS-Prozess**

(71) Anmelder: Infineon Technologies AG, 81541 München (DE)
(72) Erfinder: Müller, Karlheinz, 84149 Velden/ Vils (DE)
(74) Vertreter: Epping, Wilhelm, Dipl.-Ing.

(57) **Zusammenfassung**

Zur Herstellung eines bipolaren Transistors in einem BICMOS-Prozeß wird in einem Emitterkontaktbereich (1) ein Platzhalter (9) ausgebildet, der als Maske bei der Implantation der Basiskontaktschicht (10) dient. Anschließend wird der Platzhalter (9) entfernt und durch das entstehende Emitterkontaktloch ein Podestkollektor und eine Basisschicht implantiert. Anschließend erfolgt die Ausbildung der Emitterschicht im Emitterkontaktloch. Durch die Anwendung des Verfahrens ergibt sich ein bipolarer Transistor mit niedrigem äußerem Basisbahnwiderstand.

## Beschreibung

Die Erfindung betrifft ein Verfahren zur Herstellung eines bipolaren Transistors in einem BICMOS-Prozeß.

Ein derartiges Verfahren ist aus der US 5,516,708 bekannt. In dem bekannten Verfahren wird auf das Substrat im Emitterkontaktbereich zunächst eine dünne Oxidschicht abgeschieden. Anschließend werden auf die dünne Oxidschicht eine Schicht aus Polysilizium und eine darüberliegende Schicht aus einem Nitrid aufgebracht. Die beiden letzten Schichten werden außerhalb des Emitterkontaktbereichs bis auf die dünne Oxidschicht zurückgeätzt, so daß nur im Emitterkontaktbereich die Schicht aus Polysilizium und die darüberliegende Schicht aus einem Nitrid stehenbleibt. Um die den Emitterkontaktbereich umschließende Basiskontaktschicht auszubilden, wird das Substrat um den Emitterkontaktbereich herum durch den Beschuß mit Ionen dotiert. In einem nächsten Verfahrensschritt läßt man die dünne Oxidationsschicht wachsen, so daß sich insgesamt eine dickere Oxidationsschicht als zuvor ergibt. Entlang dem äußeren Rand des Emitterkontaktbereichs entsteht dadurch eine äußere wulstartige Verdickung der Oxidschicht, die nachfolgend als Abstandsstück bezeichnet wird. Nach dem Aufoxidieren der dünnen Oxidschicht wird im Emitterkontaktbereich die oben aufliegende Nitridschicht und das darunterliegende, in einem Mittenbereich noch vorhandene Polysilizium entfernt. Dadurch werden die Abstandsstücke freigelegt und es ergibt sich im Emitterkontaktbereich eine Oxidschicht, die ein topfartiges Profil aufweist. Danach erfolgt im Emitterkontaktbereich durch die Oxidschicht hindurch die Implantation der Basisschicht im Substrat. Schließlich wird im Emitterkontaktbereich eine Emitterschicht aus Polysilizium abgeschieden. Daran schließt sich das Ausbilden von seitlichen Abstandsstücken und die Kontaktierung der Emitterschicht und der Basiskontaktschicht an.

Ein Nachteil des bekannten Verfahrens ist, daß die Breite des Emitters durch den Innendurchmesser des am Rand der Emitterkontaktzone umlaufenden Abstandsstücks abhängt. Denn das Abstandsstück wird in einem Oxidationsprozeß erzeugt, der in seinem Ablauf nur schwer kontrollierbar ist. Außerdem erfolgt die Implantation der Basis durch die Oxidschicht hindurch, was eine unterschiedliche Dotierung der Basisschicht zur Folge hat, insbesondere in den äußeren unter dem Abstandsstück gelegenen Bereichen der Basisschicht. Aufgrund der schwachen Dotierung der äußeren Basisschicht ergibt sich ein hoher äußerer Basiswiderstand zwischen dem Rand des Emitters und dem Beginn der Basiskontaktschicht. Der äußere Basisbandwiderstand wird darüber hinaus aufgrund der erwähnten Unsicherheiten bei der Herstellung des Abstandsstücks aus der dünnen Oxidschicht stark schwanken. Beide Effekte sind für das Hochfrequenzverhalten des bipolaren Transistors nachteilig.

Ausgehend von diesem Stand der Technik liegt der Erfindung die Aufgabe zugrunde, ein in einem BICMOS-Prozeß integrierbares Herstellungsverfahren für bipolare Transistoren mit geringem äußeren Basisbahnwiderstand anzugeben.

Diese Aufgabe wird erfindungsgemäß durch ein Verfahren mit den Merkmalen nach Anspruch 1 gelöst.

Bei den Verfahren gemäß der Erfindung dient der Platzhalter zum einem dazu, das Substrat während der Implantation der Basiskontaktschicht abzudecken und dadurch die Ausdehnung der Basiskontaktschicht zum Emitterkontaktbereich zu bestimmen. Die Abmessungen des Platzhalters bestimmen zum andern auch die Ausdehnung des Emitterkontaktlochs und damit die Ausdehnung der durch das Emitterkontaktloch hindurch im Substrat implantierten Basisschicht. Durch das erfindungsgemäße Verfahren wird somit eine zur Basiskontaktschicht komplementäre Basisschicht ausgebildet. Dadurch schließt die Basisschicht unmittelbar an der Basiskontaktschicht an, was einen geringen äußeren Basisbahnwiderstand zur Folge hat.

Die Breite des Emitters wird schließlich bei dem erfindungsgemäßen Verfahren durch die Abstandsstücke im Emitterkontaktloch bestimmt. Dadurch wird die Breite des Emitters wesentlich genauer als beim Stand der Technik definiert.

Weitere zweckmäßige Ausgestaltungen der Erfindung sind Gegenstand der abhängigen Ansprüche.

Nachfolgend werden Ausführungsbeispiele der Erfindung anhand der beigefügten Zeichnung erläutert. Es zeigen:
- Figur 1 bis 4: jeweils Querschnitte durch einen Schichtaufbau auf einem Substrat zu aufeinanderfolgenden Zeitpunkten während der Ausführung eines ersten Ausführungsbeispiels des erfindungsgemäßen Verfahrens;
- Figur 5 bis 9: Querschnitte durch einen Schichtaufbau auf einem Substrat während der Ausführung eines abgewandelten Ausführungsbeispiels der Erfindung;
- Figur 10 bis 14: Querschnitte durch einen Schichtaufbau, der bei der Anwendung eines weiteren Ausführungsbeispiels der Erfindung entsteht;
- Figur 15 bis 18: Querschnitte durch einen Schichtaufbau, bei dessen Herstellung die selektive Abscheidung einer Isolierschicht zur Anwendung kommt; und
- Figur 19 bis 22: Querschnitte durch einen Schichtaufbau, der bei der Anwendung eines abgewandelten Verfahrens mit selektiver Abscheidung der Isolierschicht entsteht.

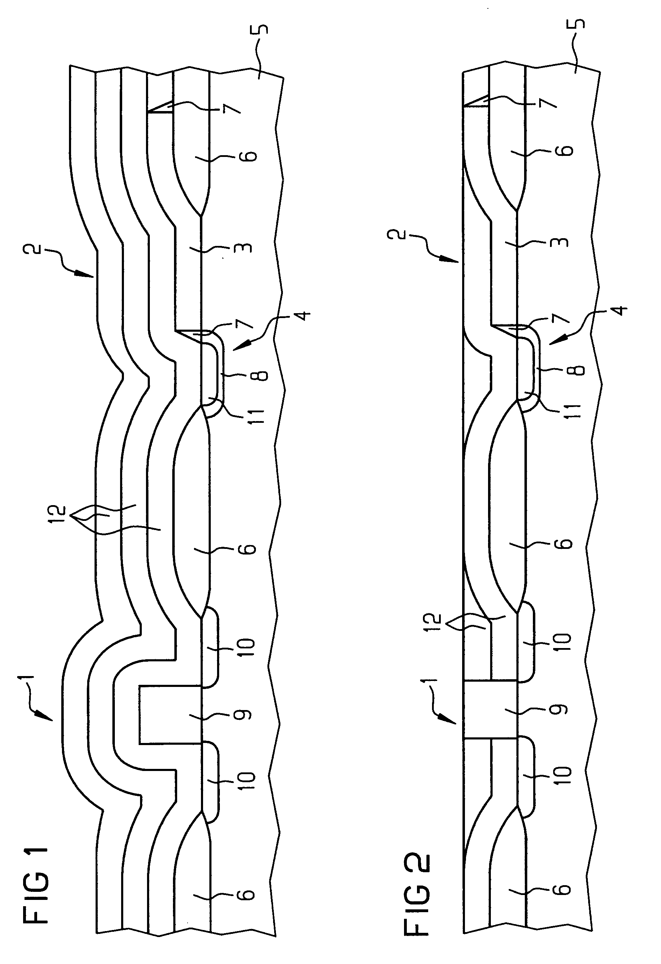

Die Figuren 1 bis 4 veranschaulichen ein in einen BICMOS-Prozeß integrierbares Herstellungsverfahren für einen bipolaren Transistor. Der Übersichtlichkeit halber ist in den Figuren 1 bis 4 nur ein Emitterkontaktbereich 1 dargestellt. Der dazugehörige Kollektorkontaktbereich ist in den Figuren 1 bis 4 nicht dargestellt. An den Emitterkontaktbereich 1 des bipolaren Transistors schließt sich ein ebenfalls nur teilweise dargestellter Feldeffekttransistor 2 mit einem Gate 3 und einer Drain 4 an. In Figur 1 und den folgenden Figuren im einzelnen nicht dargestellt ist ein Substrat 5, auf dem sich der Schichtaufbau befindet.

Zur Herstellung des Schichtaufbaus werden auf dem Substrat 5 zunächst die Isolierbereiche 6 aus Feldoxid hergestellt. Danach erfolgt die Abscheidung und Strukturierung einer Schicht aus Polysilizium, die unter anderem das Gate 3 des Feldeffekttransistors 2 bildet. Durch Implantation wird dann im Substrat 5 ein leicht dotierter Bereich 8 der Drain 4 ausgebildet.

An diese Herstellungsschritte schließt sich die Bearbeitung des Emitterkontaktbereichs 1 an. In einem ersten Schritt wird im Emitterkontaktbereich ein Platzhalter 9, beispielsweise aus einem Nitrid hergestellt. Der Platzhalter 9 dient in einem nachfolgenden Implantationsvorgang als Maske, um eine im Substrat 5 implantierte hochdotierte Basiskontaktschicht 10 in ihrer Ausdehnung nach innen hin zu begrenzen. Im gleichen Verfahrensschritt wird auch eine Drainkontaktschicht 11 im Bereich des Feldeffekttransistors 2 implantiert.

Die so gewonnene Struktur wird von Isolierschichten 12 überdeckt, die beispielsweise aus Tetra-Ethyl-Ortho-Silikat hergestellt werden. Wie in Figur 2 dargestellt werden die Isolierschichten anschließend durch Chemisch-Mechanisches Polieren eingeebnet. Dabei wird der Platzhalter 9 freigelegt. Außerdem wird der auf dem Isolierbereich 6 aufliegende Teil der das Gate 3 bildenden Schicht teilweise freigelegt.

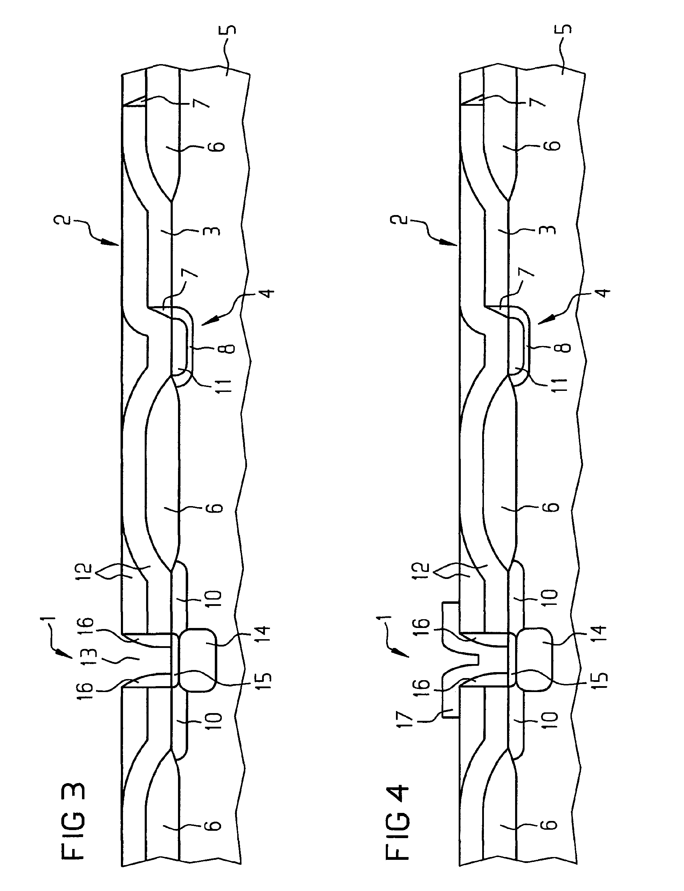

Danach erfolgt gemäß Figur 3 das Ausätzen des Platzhalters 9, so daß ein Emitterkontaktloch 13 entsteht. Durch das Emitterkontaktloch 13 hindurch erfolgt zunächst auch die Implantation eines Podestkollektors 14. Ein derartiger Podestkollektor 14 wird häufig auch als SIC (Selectively Implanted Collector) bezeichnet. Oberhalb des Podestkollektors 14 wird danach eine Basisschicht 15 implantiert. Da der Platzhalter 9 zum einen die seitliche Ausdehnung der Basiskontaktschicht 10 nach innen hin begrenzt und zum anderen die seitliche Ausdehnung des Emitterkontaktlochs bestimmt, entsteht durch die Implantation der Basisschicht 15 eine zur Basiskontaktschicht 10 komplementäre Basisschicht 15. Infolgedessen schließt die Basisschicht 15 unmittelbar an die hoch dotierte Basiskontaktschicht 10 an.

Auf den Implantationsvorgang folgt die Herstellung von Abstandsstücken 16 im Emitterkontaktloch 13.

Im nächsten, in Figur 4 dargestellten Verfahrensschritt wird die Emitterschicht 17 im Emitterkontaktloch 13 abgeschieden. Die Breite der an der Basisschicht 15 anliegenden Emitterschicht 17 wird durch den Abstand der Abstandsstücke 16 bestimmt. Die Genauigkeit bei der Fertigung der Abstandsstücke 16 bestimmt somit auch die Schwankungsbreite des äußeren Basisbahnwiderstands zwischen dem Rand der Emitterschicht 17 und der Basiskontaktschicht 10.

Abschließend kann die Emitterschicht 17 an in Figur 4 nicht dargestellte, zu darüberliegende Leiterbahnen aus Metall führende Vias angeschlossen werden.

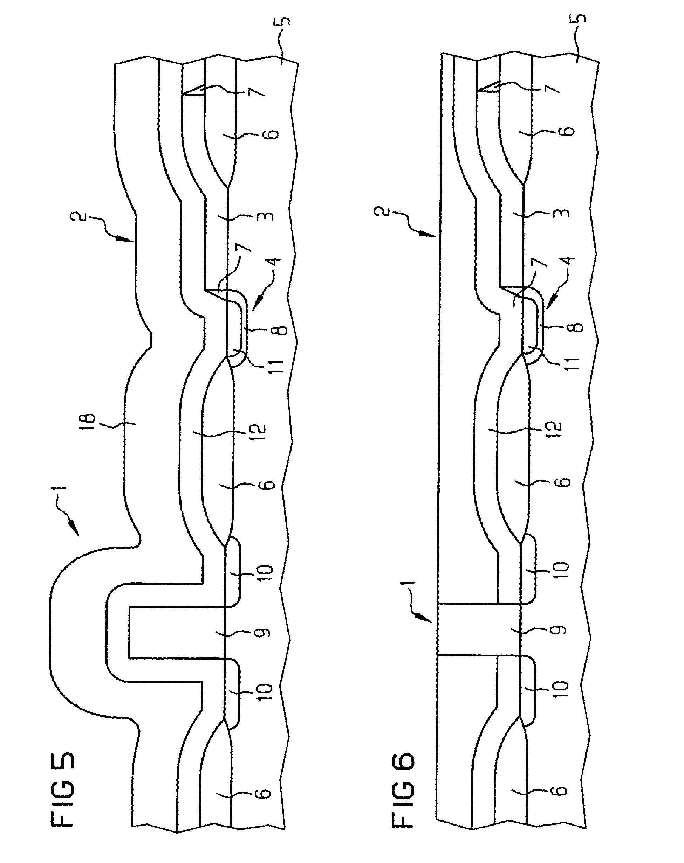

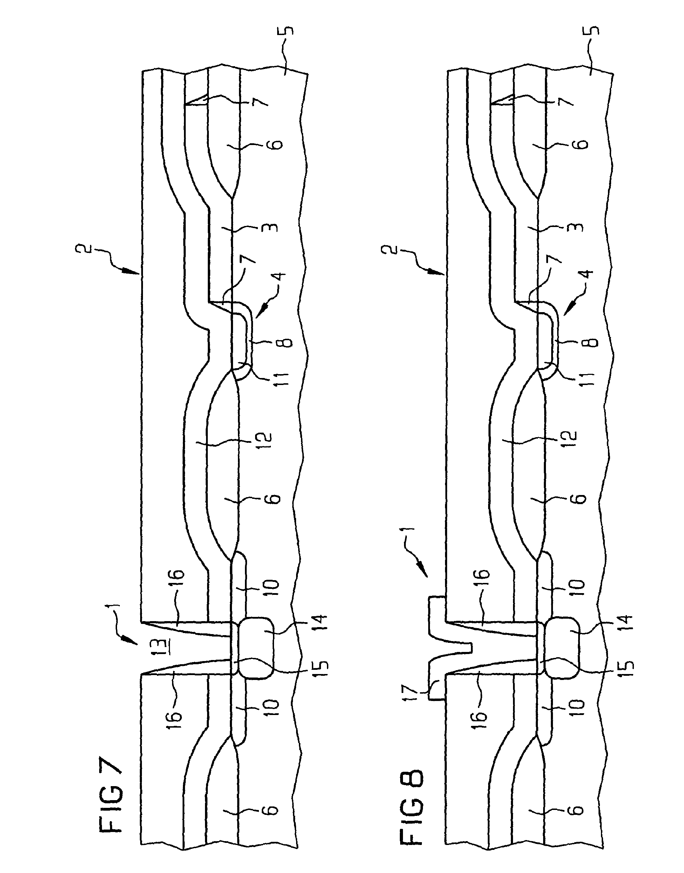

Bei dem in den Figuren 5 bis 9 dargestellten, abgewandelten Ausführungsbeispiel ist der Anschluß an Leiterbahnen auf andere Art und Weise vorgenommen worden. Wie aus Figur 5 hervorgeht, ist auf die Isolierschicht 12 aus Tetra-Ethyl-Ortho-Silikat eine weitere Isolierschicht 18 aus borhaltigem Phosphorglas (BPSG) aufgebracht. Letztere Schicht wird beispielsweise durch Chemisch-Mechanisches Polieren eingeebnet, so daß der Platzhalter 9 freigelegt wird. Die übrigen Verfahrensschritte werden genauso wie bei dem in den Figuren 1 bis 4 dargestellten Ausführungsbeispiel durchgeführt. Im Unterschied zu dem in den Figuren 1 bis 4 dargestellten Ausführungsbeispiel gestattet die Isolierschicht 18 aus borhaltigem Phosphorglas jedoch das unmittelbare Aufbringen einer Leiterbahn 19 auf der Emitterschicht 17. Entsprechend wird die Drainkontaktschicht 11 über ein Via 20 mit einer Leiterbahn 21 verbunden.

Das in den Figuren 5 bis 9 vorgestellte Verfahren gestattet somit, einen besonders flachen Schichtaufbau herzustellen. Es erfordert jedoch eine genaue Justierung des Ionstrahls bei der Implantation des Podestkollektors 14 und der Basisschicht 15, um unerwünschte Abschattungen des Ionenstrahls zu verhindern.

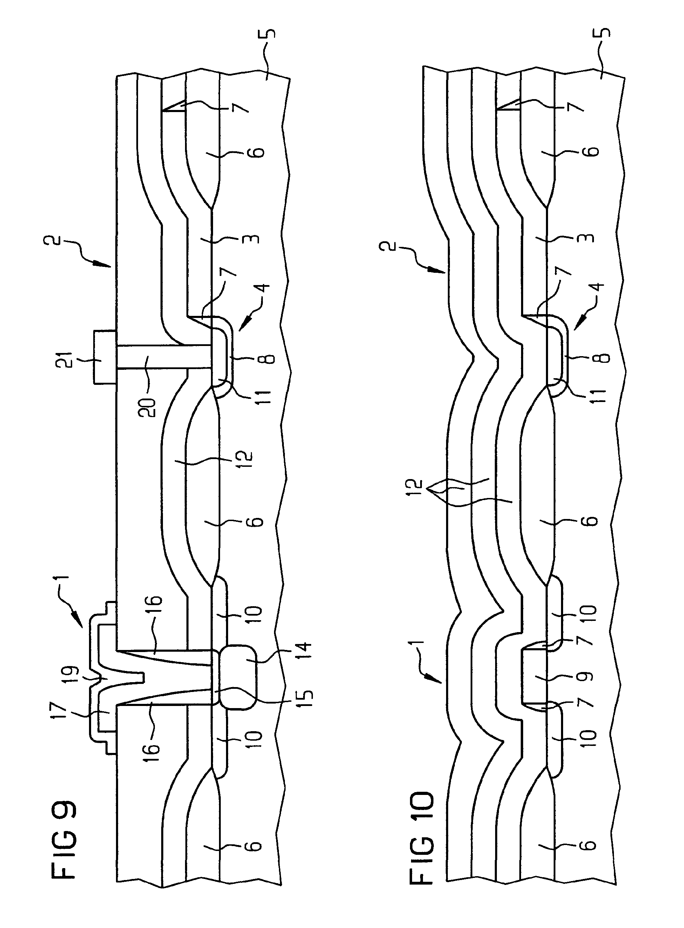

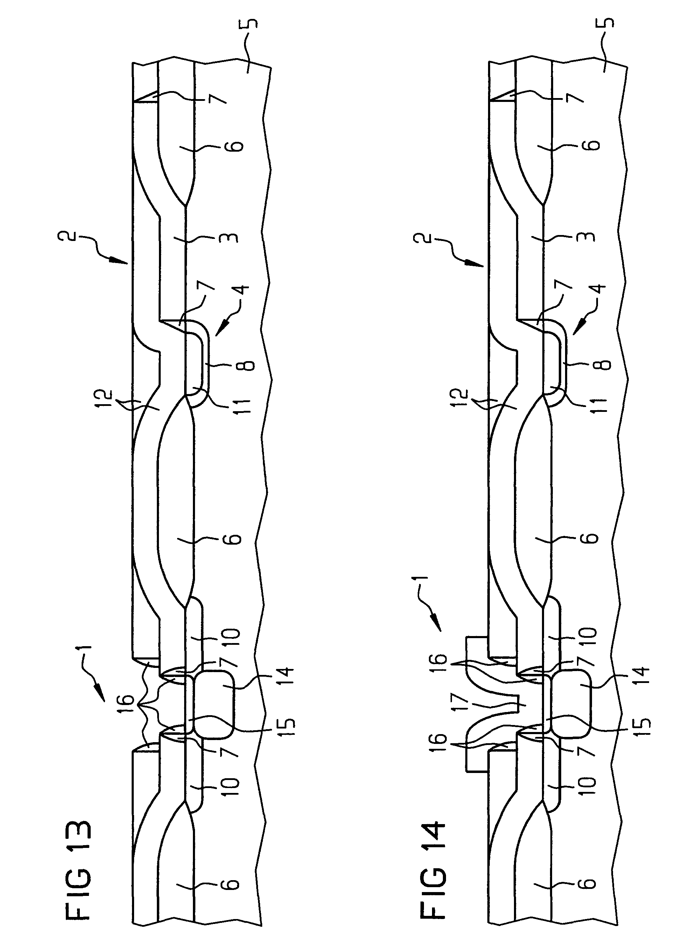

Ein weiteres abgewandeltes Verfahren ist in den Figuren 10 bis 14 dargestellt. Im Gegensatz zu den bereits beschriebenen Verfahren gemäß den Figuren 1 bis 9 ist hier der Platzhalter 9 von der gleichen Schicht gebildet, die auch das Gate 3 des Feldeffekttransistors 2 bildet. Folglich besteht der Platzhalter 9 nicht wie bei den Ausführungsbeispielen aus den Figuren 1 bis 9 aus einem Nitrid, sondern aus Polysilizium. Außerdem sind an den Platzhalter 9 außen Abstandsstücke 7 angesetzt. Da die Isolierschichten 12 nur soweit abgetragen werden, bis der im Isolierbereich 6 auf dem Feldoxid aufliegende Teil der Gateschicht 3 freigelegt ist, ist es erforderlich, in einem zusätzlichen Arbeitsschritt den Platzhalter 9 freizulegen, so daß dieser entfernt werden kann.

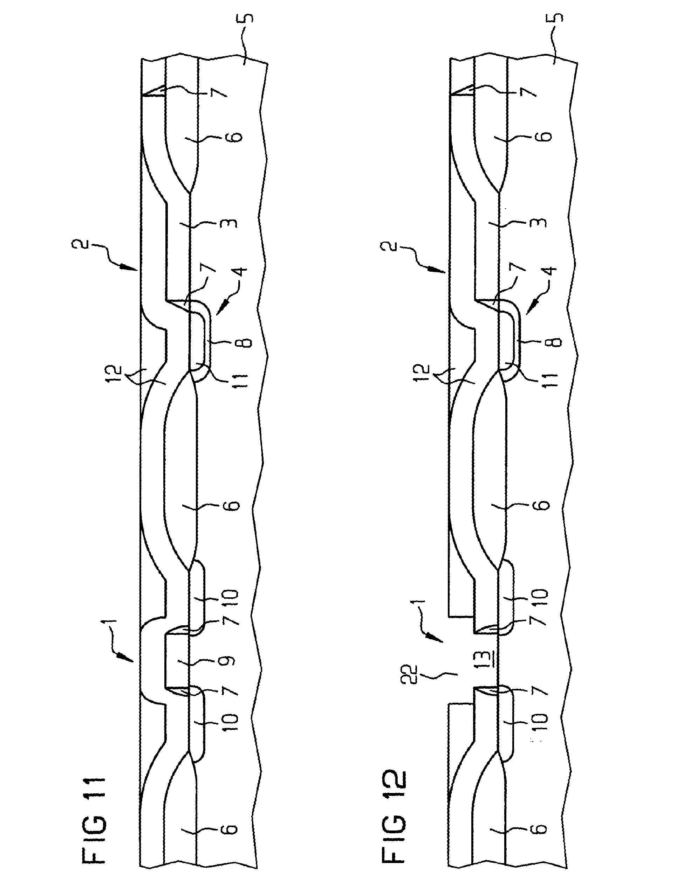

Wie in Figur 12 dargestellt, wird zu diesem Zweck oberhalb des Platzhalters 9 eine Zugangsöffnung 22 ausgeätzt. Zweckmäßigerweise ist die seitliche Ausdehnung der Zugangsöffnung 22 größer als die seitliche Ausdehnung des eigentlichen Emitterkontaktlochs 13, so daß keine hohe Justiergenauigkeit bei der Herstellung der Zugangsöffnung 22 erforderlich ist. Die nachfolgenden Verfahrensschritte werden ebenso wie die entsprechenden Verfahrensschritte bei den beiden in den Figuren 1 bis 9 dargestellten Ausführungsbeispielen ausgeführt. Aufgrund der mehrstufigen Gestalt von Zugangsöffnung 22 und Emitterkontaktloch 13 sind die Abstandsstücke 16 jedoch auf das eigentliche Emitterkontaktloch 13 und die Zugangsöffnung 22 aufgeteilt.

Das in den Figuren 10 bis 14 vorgestellte Verfahren ist insofern günstig, als für die Ausbildung des Platzhalters 9 kein zusätzlicher Prozeßschritt erforderlich ist. Dafür muß jedoch ein zusätzlicher Ätzschritt zum Ausätzen der Zugangsöffnung 22 in Kauf genommen werden. Darüber hinaus wird die Implantation der Basiskontaktschicht 10 durch die Abstandsstücke 7 am Platzhalter 9 behindert.

Den anhand der Figuren 1 bis 14 beschriebenen Ausführungsbeispielen ist gemeinsam, daß die Isolierschichten 12 ganzflächig aufgetragen werden und anschließend soweit abgetragen werden, bis der Platzhalter freigelegt ist. Es sind jedoch auch Verfahren bekannt, mit denen eine Isolierschicht aus einem Oxid selektiv auf ein Substrat aufgebracht wird. Ein derartiges Verfahren ist das sogenannte SELOX-Verfahren, in dem durch Ozon aktiviertes Tetra-Ethyl-Ortho-Silikat auf monokristallines Silizium aufgebracht wird.

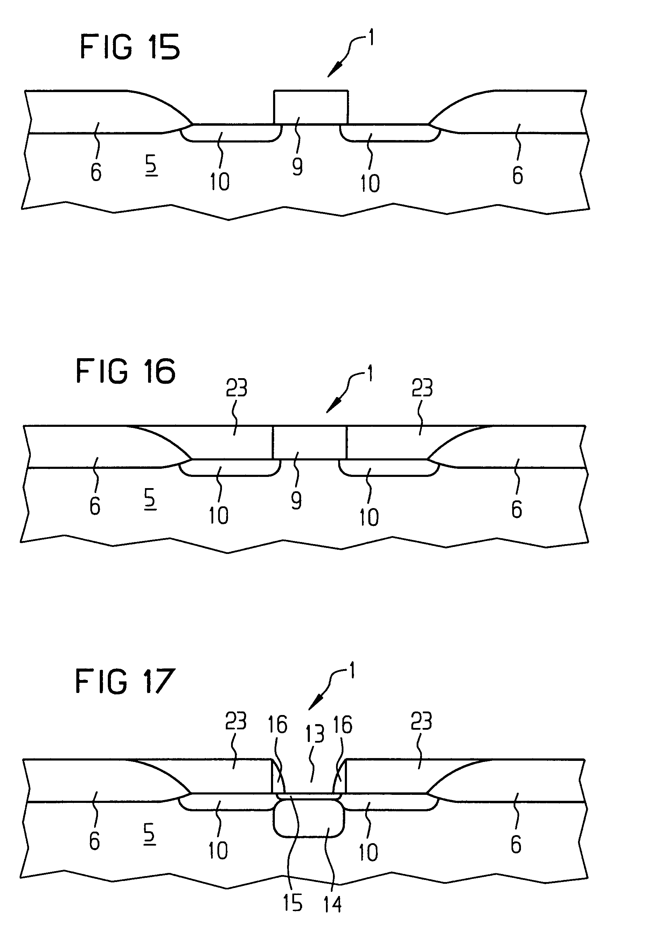

Bei dem in den Figuren 15 bis 18 dargestellten Verfahren wird zunächst der Platzhalter 9 im Emitterkontaktbereich ausgebildet. In diesem Fall handelt es sich um einen Platzhalter aus einem Nitrid, der auf das Substrat 5 aus Silizium aufgebracht ist. Anschließend wird die Basiskontaktschicht 10 implantiert, wobei der Platzhalter 9 als Maske verwendet wird. In einem weiteren Verfahrensschritt wird daraufhin der Raum oberhalb der Basiskontaktschicht 10 im SELOX-Verfahren selektiv mit einer Isolierschicht 23 gefüllt. Die Dicke der Isolierschicht 23 entspricht dabei der Dicke des Platzhalters 9. Anschließend wird der Platzhalter 9 ausgeätzt und der Podestkollektor 14 und die Basisschicht 15 implantiert. Danach erfolgt die Herstellung der Abstandsstücke 16 und die darauffolgende Abscheidung der Emitterschicht 17.

Dieses Verfahren hat den Vorteil, daß kein Einebnen der Isolierschicht 23 erforderlich ist, um den Platzhalter 9 freizulegen.

In einer bevorzugten Ausführungsform der Erfindung ist der Platzhalter 9 ein Teil der Gateschicht 3. Der Platzhalter 9 wird zusammen mit dem Gate des Feldeffekttransistors 2 ausgebildet und ist wie dieser seitlich von Abstandsstücken 7 begrenzt. Da die Prozeßführung zur Ausbildung des Platzhalters 9 die gleiche ist wie die zur Ausbildung des Gates des Feldeffekttransistors, umfaßt die Basiskontaktschicht 10 jeweils einen leicht dotierten Bereich 24 und einen hoch dotierten Bereich 25. Der leicht dotierte Bereich der Basiskontaktschicht 24 entspricht dabei dem leicht dotierten Bereich 8 des Feldeffekttransistors 2 und der hoch dotierte Bereich der Basiskontaktschicht 25 entspricht der Drainkontaktschicht 11 des Feldeffekttransistors 2.

Anschließend wird der Raum über der Basiskontaktschicht 10 im SELOX-Verfahren selektiv mit der Isolierschicht 23 gefüllt. Die Höhe der Isolierschicht 23 entspricht dabei im wesentlichen der Höhe des Platzhalters 9. Anschließend wird der Platzhalter 9 ausgeätzt und die Basisschicht 15 sowie der Podestkollektor 14 implantiert. Schließlich erfolgt das Abscheiden der Emitterschicht 17.

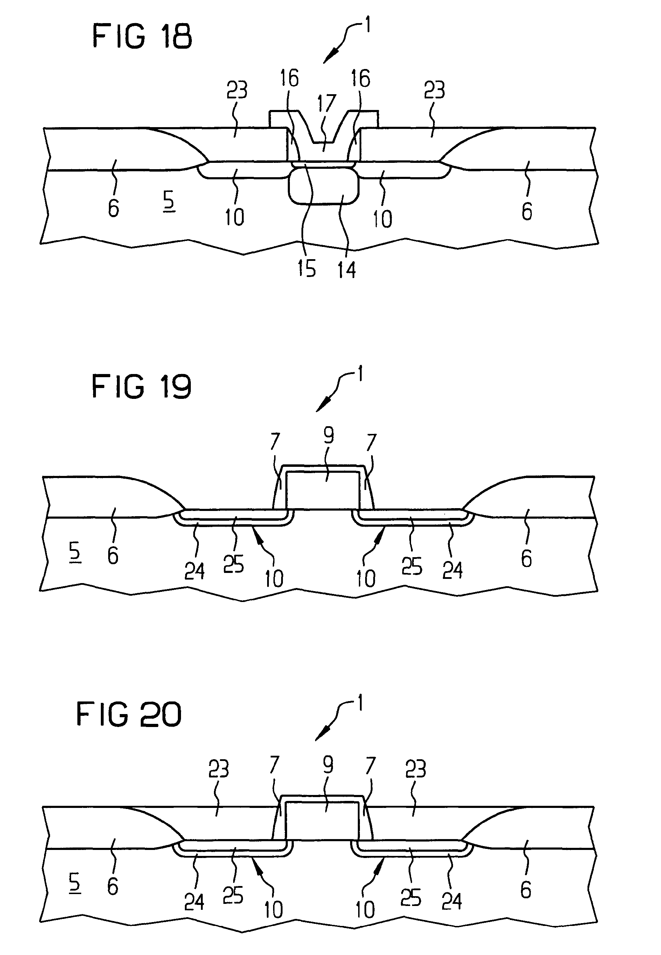

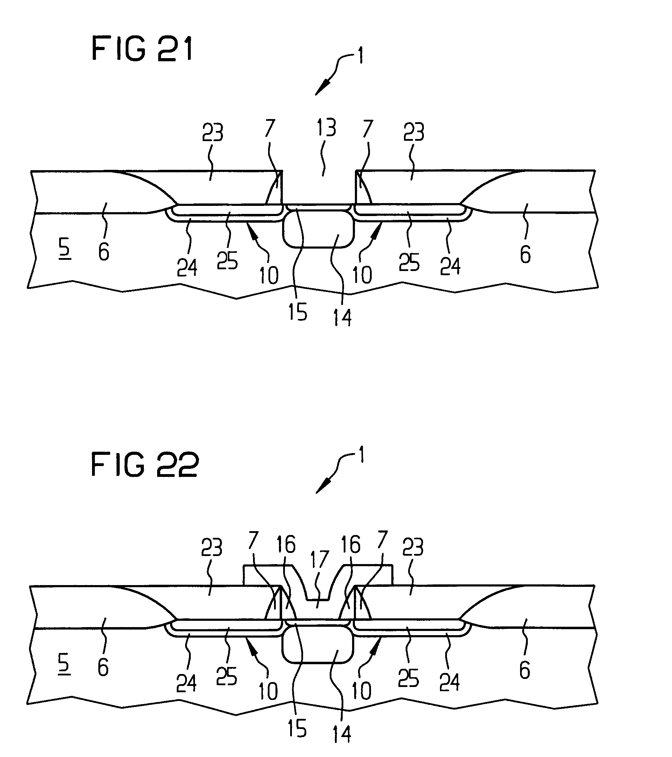

Gegenüber dem Verfahren aus den Figuren 15 bis 18 weist das Verfahren aus den Figuren 19 bis 22 den zusätzlichen Vorteil auf, daß für das Ausbilden des Platzhalters 9 kein zusätzlicher Prozeßschritt erforderlich ist. Die vollkommene Integration in den Herstellungsvorgang für den Feldeffekttransistor 2 wird auch nicht dadurch erschwert, daß wie im Ausführungsbeispiel der Figuren 10 bis 14 ein zusätzlicher Ätzschritt zur Ausbildung der Zugangsöffnung 22 erforderlich ist.

Es sei angemerkt, daß es zur Ausführung des hier beschriebenen Verfahrens nicht auf bestimmte Materialien ankommt. Wesentlich ist die Verwendung des Platzhalters 9 und die dadurch erzielten Vorteile bezüglich der Größe und der Genauigkeit des so hergestellten bipolaren Transistors.

## Patentansprüche

1. Verfahren zur Herstellung eines bipolaren Transistors in einem BICMOS Prozeß mit folgenden Verfahrensschritten:
- Abscheiden und Strukturieren eins Platzhalters auf einem Substrat (5) in einem Emitterkontaktbereich (1);
- Herstellen einer Basiskontaktschicht (10, 24, 25) neben dem Emitterkontaktbereich (1);
- Ausbilden einer Isolierschicht (12, 23) oberhalb der Basiskontaktschicht (10, 24, 25);
- Entfernen des Platzhalters (9) zur Bildung eines Emitterkontaktlochs (13);
- Herstellen einer in ihrer Ausdehnung seitlich durch das Emitterkontaktloch (13) begrenzten Basisschicht (15);
- Ausbilden von Abstandsstücken (16) im Emitterkontaktloch (13); und
- Ausbilden einer Emitterschicht (17) im Emitterkontaktloch (13).

2. Verfahren nach Anspruch 1,
**dadurch gekennzeichnet**,
daß die Basisschicht (15) implantiert wird.

3. Verfahren nach Anspruch 1 oder 2,
**dadurch gekennzeichnet**,
daß die Basiskontaktschicht (10, 24, 25) durch Implantation hergestellt wird.

4. Verfahren nach Anspruch 3,
**dadurch gekennzeichnet**,
daß die Basiskontaktschicht (10, 24, 25) in eine leicht dotierte Zone des Substrats implantiert wird.

5. Verfahren nach einem der Ansprüche 1 bis 4,
**dadurch gekennzeichnet,**
daß unterhalb der Basisschicht (15) ein Podestkollektor (14) implantiert wird.

6. Verfahren nach einem der Ansprüche 1 bis 5,
**dadurch gekennzeichnet,**
daß der Platzhalter (9) aus einem Nitrid hergestellt wird.

7. Verfahren nach einem der Ansprüche 1 bis 5,
**dadurch gekennzeichnet,**
daß der Platzhalter (9) aus Polysilizium hergestellt wird.

8. Verfahren nach einem der Ansprüche 1 bis 7,
**dadurch gekennzeichnet,**
daß der Platzhalter (9) vor dem Entfernen durch Einebnen der Isolierschicht (12) freigelegt wird.

9. Verfahren nach einem der Ansprüche 1 bis 7,
**dadurch gekennzeichnet,**
daß der Platzhalter (9) vor dem Entfernen durch Ausätzen der Isolierschicht (12) freigelegt wird.

10. Verfahren nach einem der Ansprüche 1 bis 9,
**dadurch gekennzeichnet,**
daß die Isolierschicht (12) aus Tetra-Ethyl-Ortho-Silikat hergestellt wird.

11. Verfahren nach einem der Ansprüche 1 bis 10,
**dadurch gekennzeichnet,**
daß die Isolierschicht (12) eine borhaltige Phosphorglasschicht umfaßt.

12. Verfahren nach einem der Ansprüche 1 bis 7,
**dadurch gekennzeichnet,**
daß die Isolierschicht (23) selektiv oberhalb der Basiskontaktzone (24, 25) abgeschieden wird.
